# EUROPEAN PATENT APPLICATION

(11) **EP 2 845 726 A1**
(43) Date of publication of application: **11.03.2015**
(21) Application number: 13182992.1
(22) Date of filing: 04.09.2013
(51) Int. Cl.: B32B 15/095, B32B 27/28, B32B 27/40, H01R 3/00, H01R 4/00, H01R 35/00, H05K 3/38

(54) **Electrically interconnecting foil**

(71) Applicant: Nederlandse Organisatie voor Toegepast -Natuurwetenschappelijk Onderzoek TNO, 2628 VK Delft (NL); IMEC VZW, 3001 Leuven (BE)
(72) Inventor: van den Ende, Daan Anton, 2628 VK Delft (NL); Kusters, Roel Henry Louis, 2628 VK Delft (NL); van den Brand, Jeroen, 2628 VK Delft (NL)
(74) Representative: Jansen, Cornelis Marinus

(57) **Abstract**

The invention relates to a bendable electrically interconnecting foil for making flexible electronic circuits, more in particular circuits comprising rigid electronic components such as integrated circuits. The foil comprises a flexible substrate and stretchable conductive tracks for connecting the electronic components. Between the substrate and the tracks a resilient layer is situated. The invention further relates to an electronic circuit comprising the bendable electrically interconnecting foil.

## Description

The present invention relates to an electrically interconnecting foil comprising a flexible substrate and a stretchable electrically conductive track.

### State of the art

Traditionally the interconnections for electronic circuits are made on rigid printed circuit boards, for example by etching a pattern in copper laminated FR4 (a flame resistant glass-reinforced epoxy). Rigid circuits boards provide mechanical protection of the electronic components against damage, in particular against damage by bending forces. Flexible electrical interconnections are for example made by copper tracks on plastic foils, for example polyester or polyimide foils. Such interconnections are used for electrically connecting moving parts in for example printers and scanners to electronics in the stationary part of the apparatus. Typically, such interconnections do not comprise electronic components but only conductive tracks.

Currently, there is an increasing demand for flexible electronics, viz. functional electronic devices that are, to a certain extent, bendable. Flexible electronics can be applied for wearable products, for example for integrating electronics in clothes. Although some electronic components, for example OLEDs (organic light emitting diodes), can be made flexible, often such components, for example ICs (integrated circuits), are rigid. To obtain a bendable device the rigid components of a device are placed on a flexible substrate comprising conductive tracks connecting the rigid components.

For certain applications it is not sufficient that the device is only bendable, it should also be stretchable, which means that the devices can be elongated and/or shortened. Stretchable devices may be preferred when incorporating the device in for example clothes. Stretching of a thin device may also occur when such a device is attached to a bending structure that is thick in comparison with the thickness of the device.

One of the problems that one encounters when making flexible electronics is that the relative thick copper tracks are stiff in comparison with the flexible substrate and that such copper tracks are not stretchable. Flexible electrical circuits boards are well known, for example from international patent application WO2012/131352. This document discloses a circuit board made out of a flexible polyurethane substrate and electrically conductive copper tracks. The tracks comprise a resilient part that allows the tracks to be stretched without being damaged when the flexible substrate is subject to tensile force. Further it is disclosed that the tracks can be sandwiched between two polyurethane substrates in order to isolate the copper tracks.

In international patent application WO2010/086034 it is considered that flexible electronic circuit boards have the disadvantage that electronic devices in which rigid components are connected by such stretchable tracks tend to break easily at the point where the track is connected to a rigid component. WO2010/086034 discloses a stretchable structure comprising an electrically conductive copper track for connecting rigid electronic components. More in particular the structure comprises a semi-transition part. This semi-transition structure which has a Young's modulus at an intermediate level between the Young's modulus of the electronic component and the Young's modulus of the flexible part of the stretchable structure allows the reduction of the strain gap between the flexible part of the stretchable structure and the electronic component. The semi-transition structure is made of copper and a bendable but not stretchable material commonly used as substrate for flexible electronic systems.

A disadvantage of electrically interconnecting foils according to the state of art is that the copper tracks of such foils exert a localized force on the electronic components that are mechanically connected with the foil, when the foil is bent. Such a force may damage the device for example by breaking the mechanical connection between the track and the component.

### Summary of the invention

An objective of the present invention is to provide an electrically interconnecting foil for improved flexible electronic circuits.

This objective of the invention is obtained by an electrically interconnecting foil comprising a flexible substrate and a stretchable electrically conductive track characterised by a resilient layer situated between the substrate and the track, mechanically connecting the track and the substrate.

An advantage of a resilient layer situated between the substrate and the track, which resilient layer is mechanically connecting the track and the substrate, is that the stress caused by for example a bending force exerted on the substrate is mitigated by the resilient layer. An effect of this mitigation is that the stress at the position where an electronic component is attached to the track is reduced when compared to an electrical interconnection foil without such an resilient layer. Reducing the stress makes that the circuit comprising the track and the electronic component is less prone to mechanical damage caused by deformation, for example bending or thermal expansion of the substrate. So, consequently, the electrically interconnecting foil according to the invention allows manufacturing improved flexible electronic circuits.

### Brief description of the figures

- Figure 1: shows a cross section of an electrically interconnecting foil.
- Figure 2: shows a top view of the electrically interconnecting foil shown in figure 1.
- Figure 3: shows a top view of another embodiment of an electrically interconnecting foil.
- Figure 4A: shows an example of a preferred single track.
- Figure 4B: shows an example of multiple preferred tracks.
- Figure 5: shows a cross section of an electronic circuit.
- Figure 6: shows a top view of an electronic circuit.
- Figure 7: shows a top view of an electronic circuit comprising an integrated circuit.

### Detailed description the invention

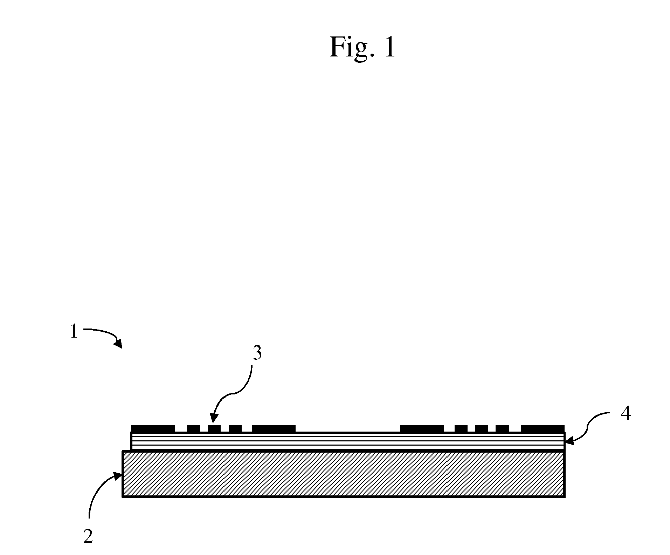

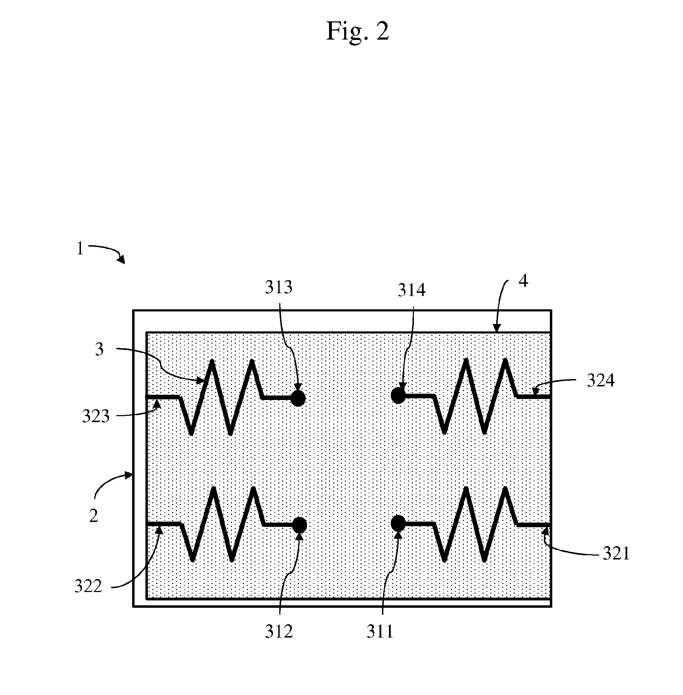

A schematic presentation of an electrically interconnecting foil is shown in the figures 1 and 2. Figure 1 is a cross section of an embodiment of such a foil comprising a stretchable electrically conductive track (3) and figure 2 is a top view of the same embodiment. The electrically interconnecting foil (1) comprises a resilient layer (4) sandwiched between a flexible substrate (2) and a stretchable electrically conductive track (3). Here, with a flexible substrate is meant a substrate that can be bent with an minimum allowable bending radius that is less than thousand times the thickness of the substrate. With minimum allowable bending radius of a substrate is meant the minimum bending radius that does not result in mechanical damage, for example plastic deformation or breaking, of the substrate. The minimum allowable bending radius may even be less than hundred times the thickness of the substrate.

Typically a flexible substrate used for flexible electronic circuits and devices is made out of a material that is electrically non-conductive, for example a plastic. The flexible substrate (2) may be a plastic foil made out of a thermoplastic polymer, for example PET (Polyethylene terephthalate), PI (Polyimide), PEEK (Polyether ether ketone), PEN (Polyethylene naphthalate), PC (Polycarbonate), HDPE (High Density Polyethylene), or PP (Polypropylene). A substrate made out of a thermoplastic polymer may comprise additives for improved thermal, mechanical or other properties. The thickness of the substrate depends, among others, on the material out of which the substrate is made and the amount of flexibility that is required. The required bending radius may be smaller than 5 centimetres. Typically, plastic substrates used for flexible electronics have a thickness between 2 micrometres and 500 micrometres, more in particular between 10 micrometres and 300 micrometres and more in particular between 20 micrometres and 150 micrometres.

The top view of the electrically interconnection foil in figure 2 shows that this embodiment of the foil comprises four stretchable electrically conductive tracks, which tracks are electrically isolated from each other. The first ends (311,312,313,314) of the tracks may be used for placing a single electronic component having four pins for electrical connection. The four first ends may also be used for placing two electronic components, each having two pins. It is appreciated that the number of ends need not to be equal to the number of pins. Some pins may not be connected to ends or multiple pins may be connected to a single end. The second ends (321,322,323,324) of the tracks may be used for connecting the electronic component or components to other parts of an electronic circuit or for external connection with for example a power supply or components. Such connection may for example be realised by soldering, glueing using a conductive adhesive or by clamping using a clamp or plug.

The stretchable electrically conductive track (3) is made out of a material that is selected from a group of electrically conductive materials. The track may for example be made out of a metal, for example a metallic foil laminated onto the flexible substrate or an otherwise uniformly deposited metallic layer, for example by coating or chemical or physical vapour deposition or (electro-)plating. To obtain the desired pattern of the track, such a uniform layer is to be patterned by for example chemical etching, mechanical cutting, laser ablation or another technique for removing parts of the metallic layer selectively. Preferably, copper is used for making conductive patterns in electronic circuits because of the good conductivity of copper. The copper may be covered with a tin layer to prevent corrosion or for better soldering. However, also other metals may be used for the electrically conductive track, for example aluminium. Typically the thickness of a copper track in flexible electronic circuits is between 1 micrometre and 100 micrometres, preferably between 5 micrometres and 20 micrometres.

The conductive track for an electronic circuit may also be made by printing a conductive ink onto the substrate, for example by inkjet printing or screen printing. An advantage of printing technique above for example lamination followed by etching is that the conductive material can be deposited directly in the required pattern. Such a conductive ink may comprise silver or other conductive materials, such as carbon (graphite, nanotubes) or nickel coated particles.

There are several methods to obtain an electrically conductive track that is stretchable. One may use a stretchable conductive material to make the conductive track, for example a rubber filled with a conductive material such as carbon or metal. Such materials, however, do not have the properties, including a high conductivity, that is required in many electronic circuits. For this reason it is preferred to make the stretchable conductive track by patterning a metallic track in a shape that allows stretching of the track. An example of such a shape is shown in figure 2 and will be discussed in more detail below. Stretching of a track means that the distance between a first end (311,312,313,314) of the track and a second end (321,322,323,324) of the track can be enlarged and reduced reversibly without plastic deformation of the track or otherwise damaging the track.

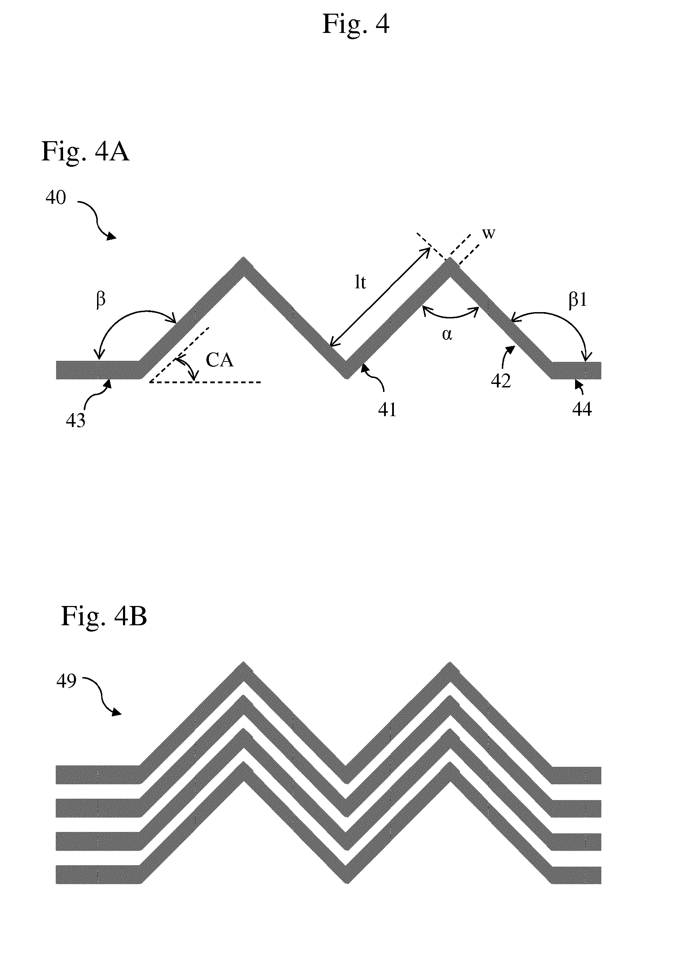

Several geometries to obtain a flexible conductive track are proposed in literature. These geometries include wavy geometries as described in WO2010/086034 and more complex geometries as described in WO2012/131352. Such track geometries can be successfully applied in the electrically conduction foil. In addition to these geometries, the inventors have found that a track geometry as described below may favourably be used for the electrically interconnecting foil. This track geometry will be described with reference to figure 4A. It should be understood that figure 4A shows only one embodiment (40) of such a track. The embodiment of the stretchable electrically conductive track shown in figure 4A comprises two V-shaped parts in series. This number, actually providing a track having a W-shape, is chosen here for illustrative purpose. The number of V-shaped parts of each track may be limited to only one but each track may also comprise three or more V-shaped parts in series. For connecting electronic components such as integrated circuits (ICs), displays, and charge-coupled devices (CCDs) having multiple connection pins, several stretchable electrically conductive track may be placed in parallel as is shown in figure 4B. Here, four parallel stretchable tracks (49) are shown, but the number of tracks may be any number, even just one as shown in figure 4A. The number of tracks may be adapted to the number of pins of an electronic component or to other characteristics of the electrical circuit of which the track is a part of.

The stretchable electrically conductive track (40) comprises at least one V-shaped electrically conductive part comprising two straight parts (41,42) further referred to as legs, each with length It and width w. The legs joining each other at one end of each leg to form the V-shape, define an angle α. The angle α is smaller than 180 degrees and may typically be smaller than 120 degrees. The track further comprises a first end part (43) and a second end part (44) for making electrical contact with electronic components or other parts of the electrical circuit the track is a part of. The first end part and the second end part may be straight parts as shown in figure 4A, each joining the V-shaped part at one of its free ends with an angle β and β1, respectively. The angles β and β1 may be chosen to be equal having a value β so that the two end parts (43) and (44) are in line as shown in figure 4A. In such an embodiment of the stretchable track, the angles α and β are related to each other by a corrugation angle CA: α = 180 deg - 2*CA and β = 180 deg - CA.

When being made of copper, a stretchable electrically conductive track typically may have a thickness between 5 and 50 micrometres, preferably about 10 micrometres. The inventors have found that the stiffness of the track decreases with increasing corrugation angle CA and with increasing ratio It/w of the length and the width of the track. To obtain a stiffness of the track that is about three orders of magnitude lower than a straight copper track, the corrugation angle can be chosen to be 45 degrees or more while the It/w ratio of the legs of the V-shaped parts is 15 (fifteen) or more. Referring to figure 4A this means that the legs of the V-shaped parts are defining an angle α that is 90 degrees or less and that the angle β is 135 degrees or less. When another material than copper is used for making the track, then other It/w ratios and other angles may be preferred, depending on the thickness of the track and the mechanical properties of the material used for making the track. In order to connect electronic components such as ICs comprising multiple connection pins, multiple tracks (49) can be placed in parallel as is shown in figure 4B.

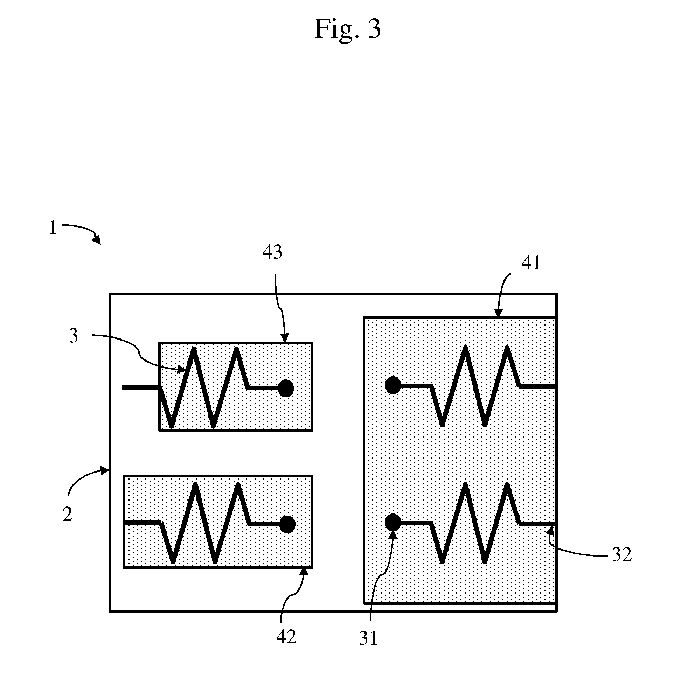

For a further discussion of the electrical interconnection foil, reference is made to figure 1 again. The foil comprises a resilient layer (4) that is situated between the flexible substrate (2) and the stretchable conductive track (3). This resilient layer is attached to both the track and the substrate and is mechanically connecting the track and the substrate. Due to this mechanical connection, the track adheres to the flexible substrate. It is understood that the mechanical connection may be a chemical or physical binding. More in particular the connection may result from a chemical reaction between the track material and the substrate material or from for example Van der Waals forces. The flexible substrate, the resilient layer, and the stretchable track form a connected foil. The resilient layer may cover the whole area of the substrate or only a part or parts of the substrate as shown in figures 2 and 3. Figure 2 is illustrative for an interconnecting foil in which the flexible substrate is laminated or otherwise uniformly covered with the resilient layer. For illustrative purpose, the resilient layer is shown not to cover the whole border of the substrate. It is understood that the resilient layer, however, may cover the whole substrate.

Figure 3 illustrates an embodiment in which the resilient layer is applied in several areas (41,42,43), which areas are spaced apart, separated by parts of the substrate (2) that are not covered by these areas. Several tracks may be applied on a single area (41) of resilient material. It is also possible to apply just one track on an area (42) of resilient material. Further, a track or more tracks may extend outside the area (43) of the resilient layer. The resilient layer may also be applied in other patterns, for example in the pattern of the track. Preferably, the stretchable track uniformly adheres to the resilient layer and the flexible substrate. However, the track may be loose from the resilient layer or the substrate at certain points or areas.

A large number of materials is suitable for making the resilient layer, provided that the resilient layer is more elastic than the flexible substrate. This will be the case when the stiffness of the resilient layer is less than 10 (ten) percent, preferably less than 1 (one) percent of the stiffness of the flexible substrate. In practise, and in case that the thickness of the resilient layer is about 10 (ten) percent of the thickness of the substrate this condition will be satisfied when the Young's modulus of the resilient layer material is lower than the Young's modulus of the substrate material. Preferably, the resilient layer is made out of material with a Young's modulus that is less than 10 (ten) percent of the Young's modulus of the material the substrate is made of. Substrate materials such as PET, PEN, PEEK and PI have a Young's modulus between 1 GPa and 10 GPa. Preferably, the resilient layer is made of a material, more in particular a rubber, with a low Young's modulus, viz. a Young's modulus that is lower than 0.1 GPa. Examples of such rubbers are PU (Polyurethane) and silicones such as PDMS (Polydimethylsiloxane). In general, the resilient layer will be electrically insulating because otherwise it may short circuit the electric circuit.

The smallest obtainable bending radius of the electrical interconnection foil will depend on the stiffness of the flexible substrate, the resilient layer, and the stretchable electrically conductive track. The extent in which the tracks contribute to the minimum obtainable bending radius depends not only on the dimensions of each track (thickness, width and length) and the material properties but also on the density of the tracks and their orientation on the substrate.

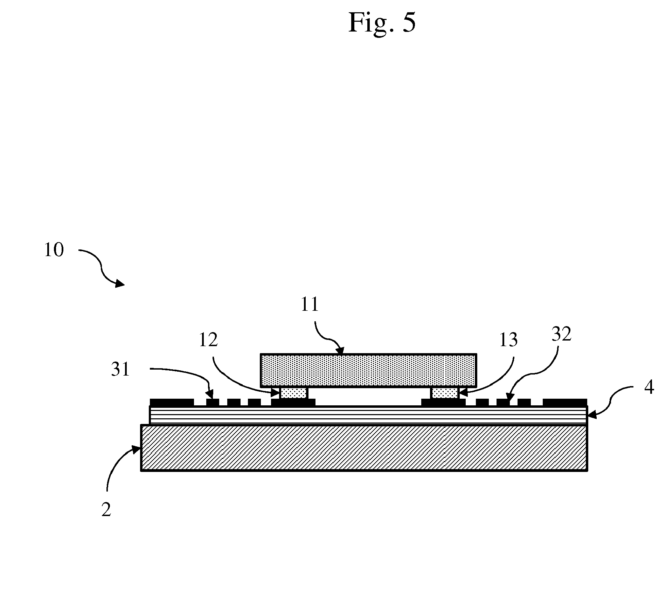

Figure 5 shows a cross section of an electronic circuit (10) comprising an electrically interconnecting foil as shown in figure 1 and an electronic component (11) attached to the foil. An electronic component is a device that requires or provides electrical power by wire or that receives or sends electrical signals by wire or that is otherwise part of an electrical circuit. The electronic component can be active or passive. Examples of passive components are resistors, capacitors, coils and switches including keyboards. Examples of active components are transistors, light emitting diodes, integrated circuits and sensors including cameras. More in particular the electronic component may be an organic electronic component comprising organic conductive or semi-conducing materials such as oligomers of polymers. Examples of such organic electronic components are organic light emitting diodes (OLEDs), organic transistors and organic photovoltaic cells (OPVs).

The electronic component is electrically and mechanically connected via connectors (12,13) with the stretchable conductive tracks (31,32). This means that an electrical current can flow from the track to the component and that the component adheres to the substrate. The connectors of the component may be pins that are glued or soldered to the track. The electrically interconnecting foil is in particular advantageous for use in flexible electronics comprising rigid electronic components, viz. components and devises that have a higher stiffness than the flexible substrate. However, the foil can also be advantageously used for flexible substrates on which fragile components are placed because the resilient layer mitigates the stress on the component. In the embodiment shown in figure 5, the resilient layer (4) almost completely covers the substrate (2) and continues in the area below the component between the connectors. Such an embodiment may be preferred for example because of reasons of easy fabrication. The resilient layer may, however also be patterned, for example as is shown in figure 3. The resilient layer may for example be attached to the substrate by laminating or the layer can be deposited on the substrate by slot die coating or other coating techniques. Forces exerted on the flexible substrate, for example by bending, can only reach the electronic component via the resilient layer. Because of the mitigating effect of the resilient layer, the electronic component is safeguarded against damaging effects of such forces. Preferably all the pins of an electronic component are attached to the substrate in such a way that a resilient layer connects each pin to the substrate via the resilient layer. However, it is appreciated that in certain circuits and certain applications it may be sufficient that not all the pins are connected to the substrate via the resilient layer.

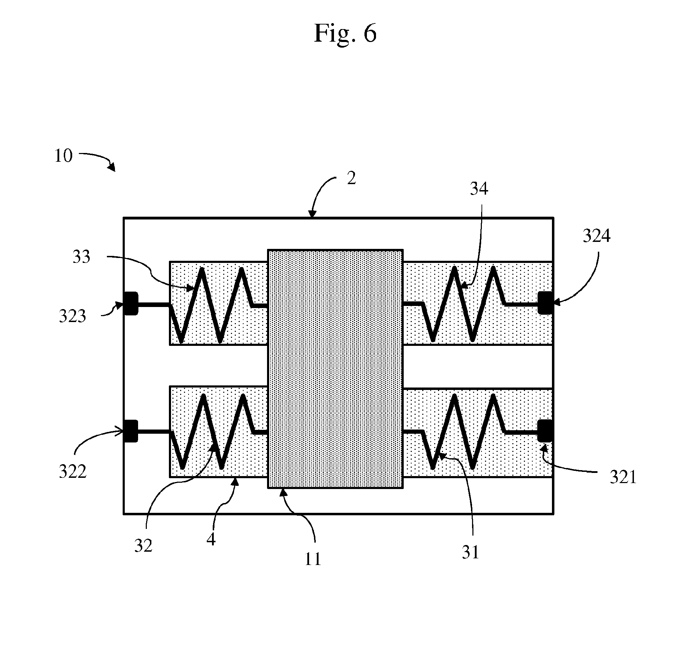

In the embodiment of the electrical circuit (10) of which a top view is shown in figure 6, the resilient layer covers only the part of the flexible substrate that is near to the electronic component (11) and the conductive tracks (31,32,33,34). The electronic component can communicate with external devices and can obtain electrical power via the connecting areas (321,322,323,324) at one end of each of the stretchable tracks. In this embodiment of the interconnection foil some of the connecting areas, viz. the areas (322) and (323) are parts of the stretchable track that extend outside the area of the resilient layer. In case that such connecting areas are not fixed to the substrate, viz. when the areas are loose ends, bending of the flexible substrate will not result in any additional forces on the component compared to the situation where the areas are fixed to the resilient layer. If, however, the connecting areas are attached directly to the substrate without a resilient layer between than the bending may result in an additional force on the stretchable track depending on the elastic properties of the substrate, the track and the resilient layer. For this reason it is preferred that the resilient layer uniformly covers the substrate under, viz. between the track and the substrate, and in the neighbourhood of the tracks.

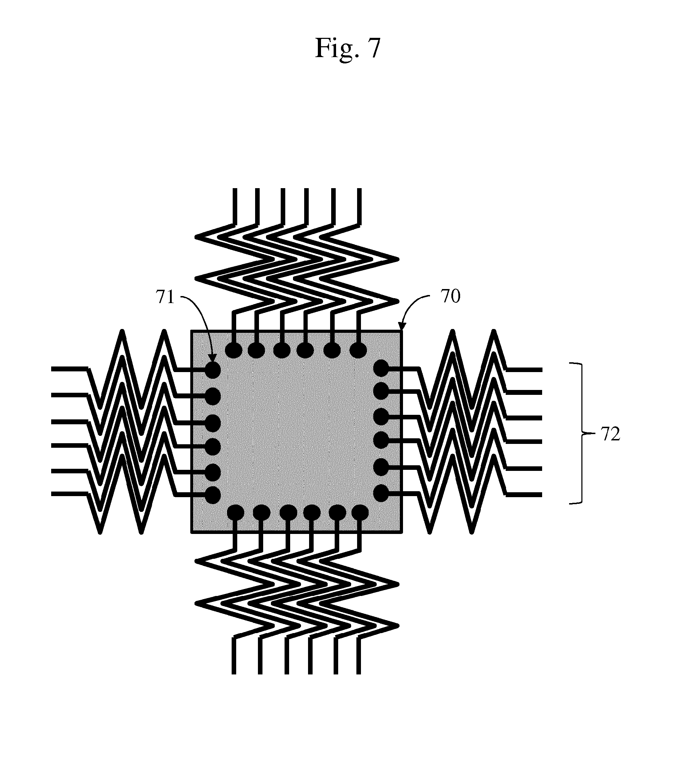

The stretchable electrically conductive tracks need not all to be directed in the same parallel direction. Figure 7 shows an integrated circuit (70) and four sets of parallel conductive tracks (72). Typically, integrated circuits are encapsulated in a rectangular housing comprising multiple connecting pins (71) at the four sides. To allow the placing of such integrated circuits, the electrically interconnecting foil may comprise conductive tracks in different directions, more in particular in perpendicular directions as shown in figure 7.

In the embodiments of the electrical connecting foil shown in the figures there is a track only at one side of the flexible substrate, viz. the upper side of the substrates in the figures 1 and 5. It is understood that the electrical lyconnecting foil may comprise a resilient layer and one or more tracks at both sides of the substrate. Electronic circuits comprising such double sided connecting foils may also comprise electronic components at both sides of the substrate.

## Claims

1. Electrically interconnecting foil (1) comprising a flexible substrate (2) and a stretchable electrically conductive track (3)
**characterised by**
a resilient layer (4) situated between the substrate and the track, mechanically connecting the track and the substrate.

2. Electrically interconnecting foil according to claim 1, wherein the flexible substrate is made out of a thermoplastic polymer.

3. Electrically interconnecting foil according to claim 2, wherein the thermoplastic polymer is selected from the group consisting of PET, PI, PEEK, PC, HDPE, PP and PEN.

4. Electrically interconnecting foil according to any of the preceding claims,
wherein the resilient layer is made out of a rubber.

5. Electrically interconnecting foil according to claim 4, wherein the rubber is a polyurethane or a silicone.

6. Electrically interconnecting foil according to any of the preceding claims,
wherein the stiffness of the resilient layer is less than 1 (one) percent of the stiffness of the flexible substrate.

7. Electrically interconnecting foil according to any of the preceding claims,
wherein the resilient layer is made out of material with a Young's modulus that is less than 10 (ten) percent of the Young's modulus of the material the substrate is made of.

8. Electrically interconnecting foil according to any of the preceding claims,
wherein the stretchable electrically conductive track is made out of a metal.

9. Electrically interconnecting foil according to claim 8, wherein the metal is copper.

10. Electrically interconnecting foil according to any of the preceding claims,
wherein the stretchable electrically conductive track comprises V-shaped parts.

11. Electrically interconnecting foil according to claim 10, wherein the legs of the V-shaped parts define an angle of 90 degrees or less.

12. Electrically interconnecting foil according to claims 10 or 11, wherein the legs of the V-shaped parts have a length over width ration It/w that is fifteen or more.

13. Electronic circuit comprising an electrically interconnecting foil according to any of the preceding claims and an electronic component attached to the foil, which component is electrically connected with the stretchable track.

14. Electronic circuit according to claim 13, wherein the electronic component is an organic electronic component.

15. Electronic circuit according to claim 14, wherein the organic electric component is an organic light emitting diode or an organic transistor or an organic photovoltaic cell.
